# EUROPEAN PATENT SPECIFICATION

(11) **EP 3 314 171 B1**
(45) Date of publication and mention of the grant of the patent: **15.04.2020**
(21) Application number: 16732279.1
(22) Date of filing: 23.06.2016
(51) Int. Cl.: F24F 6/02, H05K 7/20

(54) **HUMIDIFIER UNIT**
BEFEUCHTEREINHEIT
UNITÉ HUMIDIFICATEUR

(30) Priority: 23.06.2015 GB 201511071
(43) Date of publication of application: 02.05.2018
(73) Proprietor: Bripco Bvba, 2000 Antwerpen (BE)
(72) Inventor: EDGE, Adrian, Cheltenham Gloucestershire GL52 3BG (GB)
(74) Representative: Abel & Imray
(86) International application number: PCT/EP2016/064623
(87) International publication number: WO 2016/207321

(56) References cited:
- EP-A2- 2 562 484
- US-A1- 2011 306 288

## Description

### Field of the Invention

The present invention concerns humidifier units. More particularly, but not exclusively, this invention concerns a humidifier unit for use in a method of cooling IT equipment in a data centre, and a data centre incorporating such a humidifier unit.

### Background of the Invention

The humidifier unit according to the present invention was made as a result of a need for a new type of humidifier unit for use in a data centre. Data centres are a late 20th Century development that continues to grow as a response to the increasing demand for computer processing capability and a recognition of the importance of IT in the place of every business and organisation today. Whereas smaller organisations have sufficient processing power with laptops, PCs and occasionally servers, larger organisations require higher capacity centralised processing to serve a wide range of needs and applications. A few years ago this capacity was supplied by large mainframe computers, but more recently the method used has been to provide data centres comprising many networked computer servers installed in racks enabling controlled and modular scaling of capacity. The racks also typically house telecommunications equipment such as routers to handle data flow between the computer servers and data flow between the data centre and the outside world.

Data centre facilities can require a floor space ranging from a few hundred square feet to a million square feet. The most prevalent size for a small data centre is five to ten thousand square feet with fifty to a hundred thousand square feet being the most common floor area requirement for a large data centre.

As data centres grow, improved methods for efficient cooling of the servers have become more sought after. In air-cooled data centres, servers are typically arranged in rows of racks separated by alternating 'hot' and 'cold' aisles. Cooling air is supplied to the cold aisles, often from an underfloor plenum via perforated floor tiles, and then drawn into the servers in racks adjacent to the cold aisle by internal server fans. The internal fans also exhaust warmed exhaust air into a hot aisle on the other side of the row of racks. In such an arrangement, it is important that the volume of cold air supplied is equal to or greater than that drawn through the servers by their internal fans. If the volume is not sufficient, then the servers can be starved of cooling air or draw in warm air from other areas of the data centre, possibly resulting in the IT equipment overheating. In a traditional data centre in which cooling air is supplied to the cold aisles via an underfloor plenum, it can be difficult to supply the cold aisles with a sufficient volume of cooling air at a given temperature because of the comparatively small cross-sectional area of the underfloor plenum. Furthermore, such underfloor plenums typically have a high air-flow resistance due to their small size, tight corners and the need to force air through perforated floor tiles, thus increasing the amount of energy required to drive air through the system. An approach to overcoming the difficulties of providing large volumes of cooling air through such high-resistance air-flow paths is to provide cooling air at a lower temperature. However, it will be appreciated that providing cooling air at a lower temperature also increases the energy usage of the data centre.

Cooling air may be provided directly or indirectly utilising the cooling effect that can be provided by means of humidifying air, for example with the use of a humidifier unit.

WO2010/139919 and WO2010/139921 (Bripco BVBA) disclose data centres in which cooling air is transported to cold aisles via a corridor at least 1.5m high, for example a personnel corridor. Entrainment of the cooling air through a corridor having a large cross-sectional area provides a low resistance air flow path enabling large volumes of cooling air to be transported around the data centre at low velocity. Those data centres also make use of 'free-air' cooling, in which air from outside the data centre is used as the cooling air. Throughout most of the year, such data centres can be operated with only adiabatic cooling of outside air, thus avoiding the cost of Direct Expansion, or "mechanical" air cooling required with systems that utilise low temperature cooling air. Adiabatic cooling is provided by means of one or more humidification units, which form part of one or more air handling units.

A disadvantage of such 'free-air' cooling methods is that the outside air must be carefully filtered and treated to avoid bringing contaminants such as particulates into the data centre, which contaminants may damage the servers. WO2011/148175 (Bripco BVBA) discloses control processes for data centres utilising 'free-air' cooling methods, which processes may comprise a 'smoke detection' system which allows the data centre to switch between modes of operation in which outside air is used as the cooling air and modes in which the cooling air consists entirely of air recirculated from within the data centre. It will be appreciated that such a system is relatively complex to operate and remains vulnerable to ingress of contaminated air if detection equipment is deficient or if the time taken for the system to switch mode is too long. Furthermore, when running in 'full recirculation' mode, the cooling system typically relies on mechanical cooling to reduce the temperature of hot air returning from the servers.

One approach to making use of 'free-air cooling' of a data centre without allowing outside air to come into regular contact with servers is to use a heat exchanger to transfer heat from the warm, recirculated data centre air to cool, outside air. US2010/0300650 (APC) discloses a data centre cooling system comprising an air-to-air heat exchanger in which warm, recirculated air inside the data centre is passed through the inside of a tube as cool outside air is circulated around the outside of the tube. Cooling of the internal recirculated air inside the tube is improved by evaporation of water running over the outside of the tube. Such a system may be referred to as employing an "indirect cooling" regime.

US2013/0081784 (AST) discloses a data centre including a passive air-to-air heat exchanger comprising heat tubes, and thus is another example of a data centre using "indirect cooling". The vertically mounted heat tubes are arranged so that their lower ends are in contact with warm, internal recirculated air from inside the data centre, while their upper ends are in contact with cool, external air drawn through the cooling unit from outside the data centre. The warm, internal air heats the fluid contained in the heat tubes, which evaporates and rises to the top of the tubes, drawing heat out of the internal air. As the cooler, outside air passes over the tops of the heat tubes, the evaporated fluid inside the tubes condenses, releasing heat to the outside air, and the condensed fluid returns to the bottom of the heat tubes. US2015/0034270 (Thermo-Tech) also discloses an air conditioning system for a data centre comprising heat pipes. The air conditioning system includes a sprayer which sprays cooling fluid onto the parts of the heat pipes in contact with the external air to improve the cooling capacity of the system.

EP2562484A2 discloses an evaporative system utilising a hydraulic device, the device comprising at least one pump and a housing with a water inlet and one or more water outlets, the pump being mounted on the housing and a water tank being provided by the housing.

The air handling units of the prior art mentioned above are rather bulky, highly engineered and comprise many parts. Air handling units in data centres that employ indirect cooling can be particularly complicated and demanding of space. A data centre air handling unit of the type employed in a direct air cooling system might have a footprint of about 45 square metres in order to support 375kw of IT load (which might occupy about 45 square metres of floor space in the data centre). By way of contrast, an air handling unit employed in an indirect air cooling system might have a footprint of about 70 square metres in order to support 375kw of IT load, and may have height requirements that exceed the normal floor height in a typical single storey data centre.

The IT industry itself has long recognised the criticality of central computing facilities and the need for energy efficient operations to control cost effectiveness. Current data centre technology is the summation of 30 years of innovation and engineering design thought and has come a long way in recent times. The increasing reliance of organisations of all types on their computing resources has led to data centres often being regarded as 'mission critical' facilities, which must be kept online at all costs. To achieve this, data centres are designed to be resilient, often with redundancy built into the design to ensure that if one component or section fails, another can take its place without interruption of the data centre's operation. For example, a data centre's power supply is typically backed up with emergency batteries and/or generators that automatically cut in in the event of a power cut, and uninterrupted power supply (UPS) systems are provided to cover any time interval between loss of external power and start-up of the backup power source.

It may be that a data centre's cooling system also needs to be resilient to failure, since allowing equipment to overheat can rapidly lead to damage to servers and ultimately to failure of the data centre. One approach to providing resilience in data centre cooling systems is to build redundancy into the design by including N+1 air handling units where only n units are required for operation of the data centre (or a particular section of the data centre in larger installations) at full load. Thus, it may be that a data centre has more air handling units than required for normal operation. For example, it may be that a minimum of two air handling units are needed in order to provide cooling of a data centre (or portion thereof) when there is full demand, thus requiring three such air handling units to be provided in order to provide the desired redundancy. Given the floor space and volume that a single air handling unit may occupy, requiring 50% more space so as to provide such "N+1" redundancy may for certain applications be difficult without compromising other aspects of what would otherwise be an efficient design. For example, if a space can be cooled adequately by means of air handling units provided one at each opposing end of a generally elongate data centre building (or by means of air handling units provided one at each opposing end of a generally elongate section of a larger data centre building), there may be insufficient space to provide a third air handling unit, without a major redesign of the overall layout of the data centre. There is also the issue of managing air flow within the data centre which may further complicate how best to provide a redundant number of air handling units. Such issues may be complicated yet further if the cooling air within the data centre is provided by means of an indirect cooling system. Providing a sufficient number of independently operable DX air-conditioning units that are provided only as a back-up means of cooling in the event of the failure of an air-handling unit might be a typical solution to the problem of how best to provide resiliency in the air cooling system used in a data centre. However, providing and running such DX air-conditioning units adds extra expense, and complexity and would result in inefficient operating of the data centre in the event of a failure in an air handling unit.

Providing redundancy in the number of air handling units provided is particularly difficult in the case of data centre using an indirect cooling regime, because of the extra space that an indirect cooling system typically requires.

The present invention seeks to mitigate one or more of the above-mentioned problems. Alternatively or additionally, the present invention seeks to provide an improved humidifier unit. Alternatively or additionally, the present invention seeks to provide an improved data centre and an improved method of cooling IT equipment in a data centre.

### Summary of the Invention

The present invention provides, according to a first aspect, a resilient evaporative humidifier unit configured for operation in a data centre. It has been recognised that there may be advantages in certain types of data centre in providing greater resilience in a humidifier unit, which leads to each humidifier unit being more over-engineered than would otherwise be the case, in order to reduce or avoid the need to provide redundancy elsewhere in the data centre. The approach adopted in the present invention is to design a new type of humidifier which can be assumed to be operational 24 hours a day, every day of the year (i.e. always operational with negligible risk of downtime), which alleviates the need to provide redundancy of the N+1 kind typically required in a data centre design. This approach thus deviates from the standard approach taken in data centre design.

According to a second aspect of the invention there is provided a humidifier unit comprising two or more sets of removable sections that in use form a wetted matrix system for humidifying air flowing along a flow path from one side of the wetted matrix system to the other, one or more water tanks for holding water, and two or more pumps, each pump being configured to pump water held in at least one such water tank to at least one of the two or more sets of removable sections. The humidifier unit is configured to operate in a first mode of operation in which all of the sets of removable sections are wetted by water from the one or more water tanks by means of operation of at least one of the two or more pumps. The first mode of operation may correspond to a maximum level of humidification required of the humidifier unit during normal operation. The first mode of operation may correspond to a set (or otherwise imposed) maximum level of operation of the humidifier unit during normal operation. The humidifier unit is also configured to operate in a second mode of operation in the event of one of the aforementioned component parts is removed or otherwise rendered non-operational. For example, it may be that the humidifier unit is also configured to operate in a second mode of operation both in the event of (a) one or more, but not all, sets of removable sections is removed (partially or completely) or otherwise rendered non-operational (partially or completely), the pumps otherwise being unaffected (for example, none of the pumps have been removed or otherwise rendered non-operational), and (b) one or more, but not all, pumps being removed or otherwise rendered non-operational, the removable sections otherwise being unaffected (for example, the removable sections have not been removed or otherwise rendered non-operational). The humidification unit may be so configured that in the second mode of operation, the humidification unit is still able to deliver the same level (for example the same maximum level) of humidification as in the first mode of operation.

A single humidifier unit according to an embodiment of the present invention is thus able to provide resiliency in that in the event of failure/removal of either a set of removable sections of wetted matrix or a pump, the unit is still able to deliver the same levels of humidification, as when fully operational. In a mission-critical application, requiring dependence on the humidification provided by a humidification unit, it may therefore be acceptable to provide only one such humidification unit if it can be demonstrated that a single-point failure in one or more critical components, such as a water pump for example, can be overcome by the humidification unit without affecting the ability of the humidification unit to deliver the maximum level of humidification that would be required of it during normal operation. It will be appreciated that the present invention thus makes it possible to provide a resilient wetted matrix humidifier that does not have a single point of failure.

It may be that there are as many pumps as there are sets of removable sections (possibly the same number of pumps as the number of removable sections and possibly more pumps). It may be that each pump is arranged to supply water to only one set of removable sections. It may be that there are only two pumps. It may be that there are only two sets of removable sections. It may be that all of the pumps are arranged to operate when the humidifier unit is operating in the first mode of operation.

The one or more tanks are arranged to hold water for use by the two or more pumps. It may be that the one or more tanks are arranged to collect excess water that drips or trickles down the wetted matrix sections. There may be two or more sets of water tanks for holding water. There may be a first set of one or more water tanks and a second set of one or more water tanks. It may be that all of the two or more sets of water tanks are arranged to receive drain water from both the first and the second sets of removable sections. Preferably, all of the two or more sets of water tanks are arranged to receive drain water directly from both the first and the second sets of removable sections, for example by each tank being arranged at least party underneath all of the sections. The or each water tank may be in the form of a trough. The first set of water tanks may be arranged to feed water to at least the first set of removable sections. It may be that the first set of water tanks may be arranged to feed water only to the first set of removable sections. It may be that the second set of water tanks is arranged to feed water to at least the second set of removable sections. It may be that the second set of water tanks is arranged to feed water only to the second set of removable sections. It may be that tanks in one set of water tanks are in fluid communication with each other, permitting water to flow between the tanks in one set. There may be an isolation valve which is operable to bring one set of water tanks into fluid communication with another set of water tanks and is operable to isolate said one set of water tanks from said another set of water tanks.

It may be that the second set of removable sections is positioned in series with the first set such that when both first set and second set are in use, air flows via both the first and second sets.

There may be two or more water inlets for supplying fresh water to the one or more water tanks. The humidifier unit may be arranged to continue humidifying air flowing along the flow path, for example maintaining the same level of humidification as before, in the event of failure of any one of the two or more water inlets.

There may be two or more water outlets from the one or more water tanks for draining water from the water tanks. The humidifier unit may be arranged to continue humidifying air flowing along the flow path, for example maintaining the same level of humidification as before, in the event of failure of any one of the two or more water outlets.

The humidifier unit may comprise a control unit. The control unit may be arranged to receive an input concerning whether one or more sets of removable sections are operational or not. The control unit may be arranged to receive an input concerning whether one or more pumps are operational. The control unit may be arranged to process such inputs and as a result cause the humidifier unit to operate in a particular way. For example, the control unit may command the first mode of operation if the inputs indicate that all sets of removable sections are operational and all pumps are operational. The control unit may command the humidifier unit to operate in the second mode of operation, if the inputs indicate one of the sets of removable sections and the pumps is non-operational. The humidifier unit may comprise at least one such control unit for each of the two or more pumps. The humidifier unit may be arranged to continue humidifying air flowing along the flow path, for example maintaining the same level of humidification as before, in the event of failure of any one of the control units. Each control unit may be associated with one pump only. It may be that the control unit receives an input indicating whether or not a different control unit is operating as expected. Such an input may be used by the control unit in deciding whether to switch between the first and second modes of operation. It may be that the control unit receives an input indicating whether or not an inlet valve is operating as expected. Such an input may be used by the control unit in deciding whether to switch between the first and second modes of operation. It may be that the control unit receives an input indicating whether or not an outlet valve is operating as expected. Such an input may be used by the control unit in deciding whether to switch between the first and second modes of operation.

The humidifier unit may have a foot-print that covers an area that is greater than 2 m². The humidifier unit may have a foot-print that covers an area that is less than 10m². The humidifier unit may be taller than 1 m high. The humidifier unit will typically be no taller than 3 m high. It may be humidifier unit comprises at least 30 separate panels of wetted matrix, possibly at least 60. Each panel may have a cross-sectional area (which faces the oncoming air-flow) of at least 0.04 m² and preferably at least 0.1 m². Each panel may have a depth of at least 0.2 m. Each set of removable sections, may comprise three or more independently removable sections. Each independently removable section may be held in a frame. Each section may define a single column of wetted matrix panels. Each panel may comprise air permeable wettable material. The panels may be held in a frame (for example a sub-frame).

It may be that parts of one set of the removable wetted matrix sections are operable independently of other parts of the same set. For example, some of the removable sections of a given set may be operable independently of other removable sections of the same set. The independently operable sections of the wetted matrix may be independently operable by means of independently changing the amount of water supplied to each such independently operable section. It may be that each section is arranged itself to have a limited, finite, number of settings (for example operating states) for varying the amount of cooling provided by an individual section. The number of settings may be fewer than five. The number of settings may be two, in that each section may itself only be controlled by selectively operating the section or not operating the section (i.e. simple "on / off' control).

The humidifier unit may be provided with, or otherwise associated with, an adjustably sized aperture, for example a bypass damper (i.e. a damper which allows air to bypass the sections of the humidifier unit). Preferably the adjustably sized aperture is arranged in parallel with the wetted matrix sections of the humidifier unit. Preferably, the adjustably sized aperture and the two or more sets of removable sections of the humidifier unit are accommodated in the same airflow channel (for example when installed in a data centre). Preferably, the airflow channel is arranged such that air flowing along the channel from a position upstream of the humidifier unit to a position downstream of the humidifier unit must pass via either one or more sections of the humidifier unit or via the adjustable aperture. The humidifier unit may be arranged such that in use air is permitted to pass through a non-operating section of the humidifier unit (i.e. a dry section of the humidifier unit). The humidifier unit may be so arranged that the amount of cooling provided by the humidifier unit depends on both how many sections of the humidifier unit are in operation and the size of the adjustably sized aperture. Such an arrangement may allow for a much finer degree of control over the amount of cooling (for example the amount of adiabatic or evaporative cooling) provided by the apparatus than could be achieved without using an adjustably sized aperture. It will be appreciated that benefit of such an arrangement may be more pronounced the lower the number of sections and the lower the number of operating states (or cooling settings) that each section has. Having such a fine degree of control available may allow the amount of cooling provided to be closely matched to the cooling demand at any given time. Having such a fine degree of control available may allow the operation of a control regime in which set points for the temperature and relative humidity of cooling air can be reached and maintained with a high degree of accuracy. For example, a method of cooling, for example IT equipment in a data centre, may utilise the aforesaid humidifier unit and adjustable aperture by operating at least one but not all of the sections, and then increasing the amount of cooling (for example providing the same rate of flow of air but at a lower temperature) by means of reducing the size of the adjustable aperture, thereby forcing more air through the sections of the humidifier unit. The method may include a step (as cooling demand increases still further) of then closing the aperture completely such that substantially all air passes through the sections of the humidifier unit. The method may include a step of then causing a further single section of the humidifier unit to become operational. A method of cooling may similarly include steps which are performed when the cooling demand is less than the cooling provided (i.e. a condition where less cooling is needed). For example, a method of cooling may utilise the aforesaid humidifier unit and adjustable aperture by operating at least two of the sections, and then decreasing the amount of cooling by means of increasing the size of the adjustable aperture, thereby passing less air through the sections of the humidifier unit and more through the aperture. The method may include a step (as cooling demand decreases still further) of then opening the aperture completely. The method may include a step of then causing a further single section of the humidifier unit to become non-operational.

According to a third aspect of the invention, there is further provided a humidifier unit comprising two or more sets of removable sections that in use form a wetted matrix system for humidifying air flowing along a flow path from one side of the wetted matrix system to the other, the humidifier unit comprising one or more water tanks for holding water, two or more pumps, each pump being configured to pump water held in at least one such water tank to at least one of the two or more sets of removable sections, two or more water outlets from the one or more water tanks for draining water from the water tanks, and two or more water inlets for supplying fresh water to the one or more water tanks, wherein the humidifier unit is arranged to continue humidifying air flowing along the flow path, for example maintaining the same level of humidification as before, in the event of failure of any one component of the group of components consisting of the two or more pumps, the two or more water outlets, and the two or more water inlets.

According to a fourth aspect of the invention, there is yet further provided a humidifier unit comprising a first set of removable sections that in use form a wetted matrix system for humidifying air flowing along a flow path from one side of the wetted matrix system to the other, a second set of removable sections that in use form a wetted matrix system for humidifying air flowing along a flow path from one side of the wetted matrix system to the other, the second set being positioned in series with the first set such that when both first set and second set are in use, air flows via both the first and second sets, two or more sets of water tanks for holding water, the two or more sets comprising a first set of one or more water tanks and a second set of one or more water tanks, wherein all of the two or more sets of water tanks are arranged to receive drain water from both the first and the second sets of removable sections, the first set of water tanks is arranged to feed water to at least the first set of removable sections, and the second set of water tanks is arranged to feed water to at least the second set of removable sections.

The humidifier unit according to any aspect of the invention may form part of a data centre cooling apparatus. For example, the humidifier unit may form part of an air handling unit for a data centre.

According to a fifth aspect of the invention, there is provided a data centre using a humidifier unit in accordance with any aspect of the present invention as claimed or described herein, including any optional features relating thereto. The humidifier unit may for example be arranged to provide, directly or indirectly, cooling air for use in cooling IT equipment, for example one or more racks of server computers, in the data centre.

According to a sixth aspect of the invention, there is provided a data centre incorporating a humidifier unit, which may be a humidifier unit in accordance with any aspect of the present invention as claimed or described herein, wherein the humidifier unit is arranged to provide cooled air for cooling IT equipment in the data centre, and wherein the humidifier unit comprises critical components and shared non-critical components, each critical component having a corresponding redundant critical component. Each such critical component and its corresponding redundant critical component, when operating, both utilise the same one or more shared non-critical components.

The data centre mentioned herein in relation to any aspect of the present invention may be one in accordance with any of the features mentioned in the "Background of the Invention" set out above.

According to a seventh aspect of the invention, there is provided a method of cooling IT equipment in a data centre with the use of a humidifier unit, for example a humidifier unit in accordance with any aspect of the present invention as claimed or described herein, including any optional features relating thereto. The method includes operating a first set of components of the humidifier unit to provide a level of humidification being the highest permitted demand of humidification that can be requested of the humidifier unit during normal operation and subsequently operating the humidifier unit to provide the same level of humidification without the use of one only of the first set of components.

It may be that the level of humidification provided corresponds to the maximum level of humidification required of the humidifier unit during normal operation. Typically a humidifier unit will have a single specified or expected rate of duty during normal operation a range of rates of duty. When a humidifier unit is used to provide cooling in a data centre, there will be demand for cooling which may vary, for example according to the outside air conditions. The data centre will typically be designed to be able to operate effectively during all expected conditions. As such there will typically be a known maximum level of demand expected of the humidifier unit. It will be appreciated that the duty rates of certain components of the humidifier unit may when all such components are operational and operating when the humidifier unit is operating at its set maximum rate may be lower than the duty rate(s) of the same component(s) of the humidifier unit when other components are non-operational and the humidifier is operating at its set maximum rate.

The first set of components may comprise critical components, each critical component having a corresponding redundant critical component. There may be a second set of shared non-critical components, such that each critical component and its corresponding redundant critical component, when operating, both utilise the same one or more shared non-critical components.

The first set of components may comprise two or more sets of removable sections that in use form a wetted matrix system for humidifying air flowing along a flow path from one side of the wetted matrix system to the other. The first set of components may comprise one or more water tanks for holding water. The first set of components may comprise two or more pumps. It may be that a pump is configured to pump water held in at least one water tank to at least one of the two or more sets of removable sections. It will be appreciated that failure of a pump would, unless adequate provision is made, rapidly lead to failure of the humidifier as the wetted matrix would no longer be supplied with water. It may be that, in a first mode of operation in which all sets of removable sections are fully wetted, one or more upstream sets of removable sections provide sufficient humidification in the air (preferably across all operating conditions, but in particular when treating air at a pressure of 105 kPa, at an incoming speed of 5 ms⁻¹, having a dry bulb temperature of 35 degrees Celsius and 10% relative humidity) that the extra humidification provided (as measured by the percentage increase in the percentage relative humidity), if any, by all of those sets of removable sections downstream thereof is less than 10% of the increase in the relative humidity effected by the one or more upstream sets of removable sections; but that, in a second mode of operation in which the one or more upstream sets of removable sections are non-operational, the humidification provided by all of those sets of removable sections downstream is at least 90% of the increase in the relative humidity effected by the humidifier unit in the first mode. Thus, it may be that when all sets of wetted matrix sections are fully wetted that a second set downstream of a first set is essentially redundant.

It may for example be that the method includes a step of operating the humidifier unit in a first mode of operation in which all of the sets of removable sections are wetted by water from the one or more water tanks by means of operation of at least one of the two or more pumps operating. It may be that the method includes a step of operating all of the two or more pumps during operation of the humidifier unit in its first mode of operation.

It may for example be that the method includes a step of operating the humidifier unit in a second mode of operation in the event of the removal or failure of one only of the first set of components. For example the second mode of operation may be used in the event that one or more, but not all, sets of removable sections are removed or otherwise rendered non-operational. The second mode of operation may be used in the event that the one of the pumps is removed or otherwise rendered non-operational.

It may be that the first set of components of the humidifier unit comprises two or more water inlets for supplying fresh water to the one or more water tanks. There may be a step of operating one only of the water inlets, whilst the other is non-operational.

It may be that the first set of components of the humidifier unit comprises two or more water outlets arranged to drain water from the water tanks. There may be a step of operating one only of the water outlets, whilst the other is non-operational.

The method may include the use of an electronic control unit. The control unit may control the performance of the steps of the method, for example effecting operation of the humidifier unit without the use of one of the first set of components, whilst maintaining the level of humidification previously provided. There may be a step of the control unit receiving an input concerning the status (e.g. operational or non-operational) of each of the components in the first set of components. For example, there may be a step of the control unit receiving an input concerning the status of each of two or more sets of removable sections that in use form a wetted matrix system. There may be a step of the control unit receiving an input concerning the status of each of the pumps.

The control unit may perform a step of detecting non-operation (e.g. failure or removal) in any one of all of the components of the first set of components. It may be that, on detection of non-operation of such a component, the control unit may be arranged to log the fault in an electronic record. It may be that, on detection of non-operation of such a component, the control unit may be arranged to generate an alert. The alert may prompt manual intervention by an on-site engineer. The alert may prompt an automatic change in the operation of the humidification unit by the control unit.

It may be that the cooling effected by the humidification unit provides indirect cooling of the IT equipment in the data centre. The concept of providing indirect data centre cooling by means of an indirect air handling unit comprising a wetted matrix humidification unit is described and claimed in PCT patent application entitled "Data Centre Cooling System" with agent's reference "P024140WO" having the same filing date as the present application. The contents of that application are fully incorporated herein by reference. The claims of the present application may incorporate any of the features disclosed in that patent application. In particular, the claims of the present application may be amended to include features relating to the use of the humidification unit of the present invention in an apparatus that provides, or a method for, indirect air cooling of a data centre as described or claimed in that copending patent application. Certain examples of the subject matter envisaged will now be briefly described.

An indirect air handling unit for a data centre will typically comprise an external air flow path arranged to be in fluid communication with air outside the data centre; and an internal air flow path arranged to be in fluid communication with air inside the data centre, the external air flow path being separated from the internal air flow path. It may be that a humidification unit is positioned in the external air flow path to provide cooling. It will be appreciated that the external air flow path is the path followed by external air used to extract heat from the data centre. In use, external air may enter through one or more external air inlets, pass along the external air flow path and then exit the through one or more external air exhausts. It will be appreciated that the internal air flow path is the path followed by the air circulated within the data centre. In use, warm return air from the servers of the data centre may pass along the internal air flow path be cooled, by a heat exchange system in thermal communication with the external air flow path, and then recirculated as supply cooling air to the servers. There may be the one or more fans being arranged to control the transport of air around the data centre to and from the servers. The external air flow path may be located above, for example directly above, the internal air flow path.

In contrast to direct free air cooling systems, the humidity of the external air used in an indirect air handling unit can be increased to a high level because the external air is not brought into direct contact with the IT equipment in the data centre, which equipment may be sensitive to high humidity levels and/or condensation. It may be that because the cooling capacity of the external air can be raised more using an indirect cooling system by adiabatic cooling of the ambient air than is possible using direct free air cooling methods. A data centre comprising an indirect air handling unit can be operated using only free air cooling more of the time than a data centre using a direct free air cooling system requiring equivalent cooling capacity. It may be that using a wetted matrix humidification unit provides greater control of the humidity and temperature of the external air that is cooled, which may provide better operating efficiency.

It will be understood that when a first component is described as being 'upstream' of a second component, the first component is located at a point along an air flow path at which it comes into contact with air flowing along the air flow path before the air comes into contact with the second component. It follows that a first component described as being 'downstream' of a second component comes into contact with air flowing along the airflow path after the air comes into to contact with the second component.

It will of course be appreciated that features described in relation to one aspect of the present invention may be incorporated into other aspects of the present invention. For example, the method of the invention may incorporate any of the features described with reference to the apparatus of the invention and *vice versa.*

### Description of the Drawings

As embodiment of the present invention will now be described by way of example only with reference to the accompanying schematic drawings of which:
Figure 1 shows a perspective view of a resilient humidifier unit according to a first embodiment of the invention which uses removable wetted matrix panels;
Figure 2 is a plan view of the humidifier unit of Figure 1;
Figure 3 shows an enlarged view of a part of Figure 2;
Figure 4 shows a perspective view of the resilient humidifier unit of the first embodiment but with the wetted matrix panels removed;
Figure 5 is a schematic diagram illustrating the control system associated with the humidifier unit of the first embodiment; and
Figure 6 is a schematic diagram of a data centre illustrating a second embodiment.

### Detailed Description

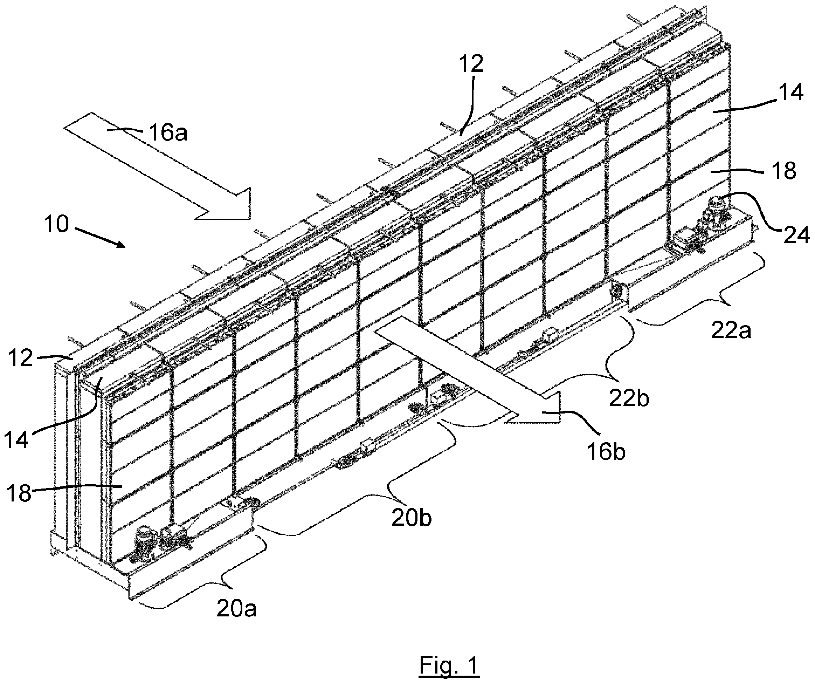

Figure 1 shows a resilient humidifier unit 10 according to a first embodiment. The resilient humidifier unit is in the form of an evaporative humidifier unit arranged to provide adiabatic changes to the air. The humidifier unit has a first set 12 of removable sections of wettable matrix on a first side of the humidifier unit and a second set 14 of removable sections on a second side of the humidifier unit, opposite to the first side. The humidifier unit 10 is shown in situ humidifying air that is flowing along a flow-path (arrows 16a, 16b) from upstream (arrow 16a) of the humidifier, onto the first side (the "air-on" side), then out (arrow 16b) from the second side (the "air-off' side). The second side (the "air-off' side) of the unit is visible in Figure 1.

The sections of wettable matrix are arranged as ten columns of wetted matrix panels 18, there being a stack of six such panels in each column. There are thus 120 wettable matrix panels in the humidifier unit. Each panel in the column is about 600mm wide, about 225mm high and about 200mm thick (deep). The humidifier unit 10 is about 6m wide, about 1.8m high and about 800mm deep. (In an alternative embodiment, the panels may be twice as high so that each column has three panels, each being about 450mm high, so that there are 60 panels in the humidifier unit. The panels might in other embodiments be 600mm high.)

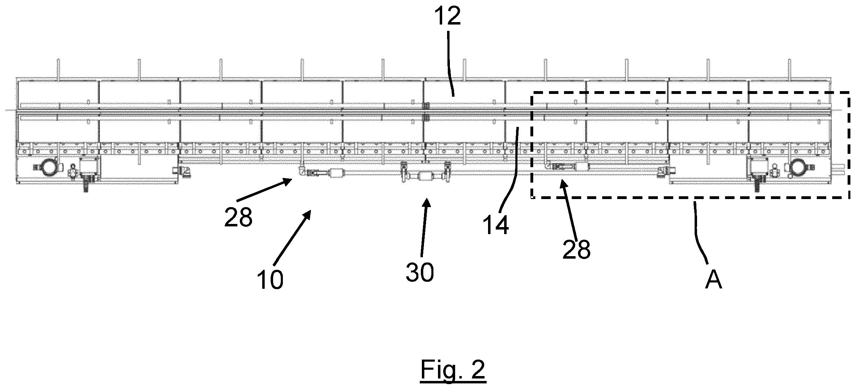

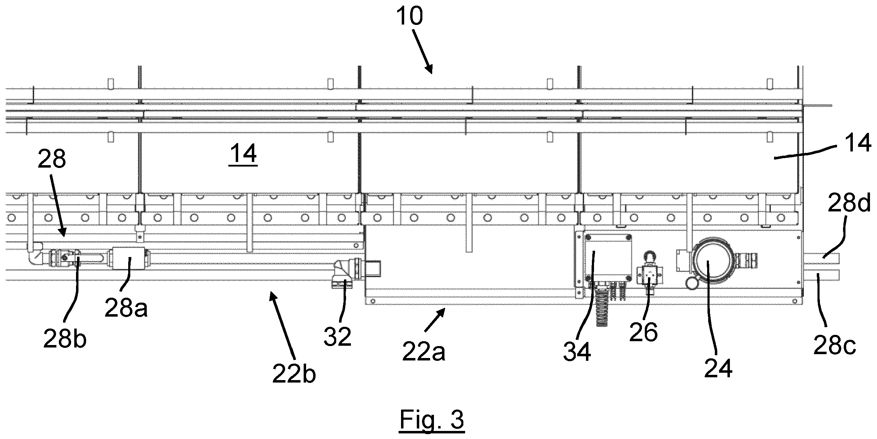

There are four water tanks, which are arranged in side-by-side arrangement, along the width of the unit arranged to collect water that falls down from the sections of wetted matrix. The tanks consist of an outer left tank 20a, and inner left tank 20b, an inner right tank 22b and an outer right tank 22a. The outer tanks 20a, 22a are two columns wide, whereas the inner tanks 20b, 22b are three columns wide. Figure 2 shows a plan view of the humidifier unit 10. The portion of the humidifier unit 10 indicated in Figure 2 with the rectangle "A" drawn with a dashed line is shown in better detail in Figure 3. The corresponding portion on the other side is symmetrical unless stated otherwise. The outer tanks 20a, 22a each accommodate a pump 24 and a water inlet 26 including its associated inlet valve. The inner tanks 20b, 22b each have a drain outlet 28 with associated drain valves. The drain outlet is primarily used when periodically refreshing the water in the tanks (as described in greater detail below). The outer tanks 20a, 22a are deeper (in the direction across the thickness / depth of the humidifier unit) than the inner tank 20b, 22b. The two tanks 20a, 20b on the left hand side are in fluid communication with each other by means of bore holes formed in the adjacent tank walls. Similarly, the two tanks 22a, 22b on the right hand side are in fluid communication. The inner tanks 20b, 22b are connected by means of a balance valve assembly 30.

It will be seen from Figure 3 that the drain valve assembly 28 comprises both a motorised drain valve 28a, and a manual (override) drain valve lever 28b. The outer tank 22a has an overflow connection 32, which provides an overflow outlet in the event that the tank overfills. The pump 24 in the outer tank is powered by means of electrical supply provided via an electrical junction box 34. The water inlet connection 26 is shown between the junction box 34 and the pump 24. The drain outlets of the left inner tank 20a and the right inner tank 22a both drain via pipes 28c, 28d on the right hand side (there are no corresponding pipes on the left hand side).

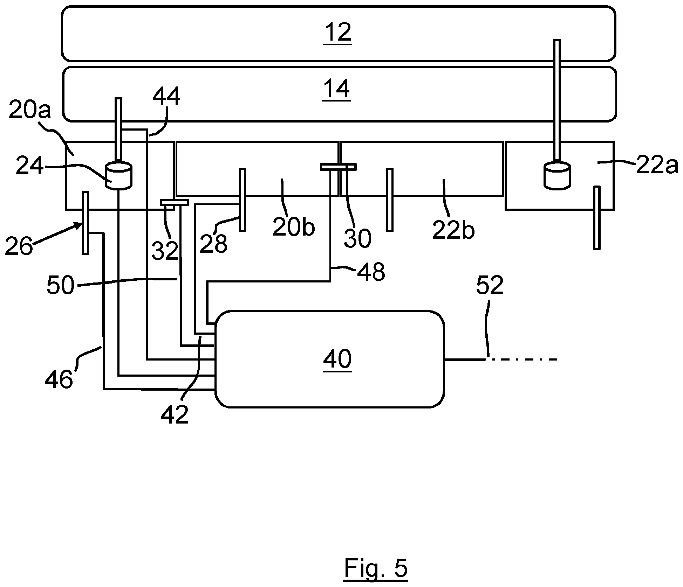

A first electronic control unit (not shown separately in Figures 1 to 4) is provided for controlling the pump 24 associated with the first set 12 of wetted matrix sections, and a second independent electronic control unit 40 (shown in Figure 5 only) is provided for controlling the pump associated with the second set 14 of wetted matrix sections.

The pump 24 in the right outer tank 22a supplies water via irrigation pipework (not shown separately in the Figures, apart from the schematic diagram of Figure 5) to the first set 12 of wetted matrix sections on the first (air-on) side of the humidifier unit 10, whereas the pump 24 in the left outer tank 20a supplies water to the second set 14 of wetted matrix sections on the second (air-off) side. The excess water that trickles down from the first set 12 of wetted matrix sections is received in each of the four tanks 20a, 20b, 22a, 22b, and similarly, drain water from the second set of wetted matrix sections 14 is also received in all four tanks.

In normal use, both pumps 24 operate to supply water from the tanks to the wetted matrix panels 18 on both the first side and the second side. Water evaporates from the sections and humidifies the air that passes through the first and second sets 12, 14 of sections. All sections of the wetted matrix are wet. Excess water falls down and drains into all tanks 20a, 20b, 22a, 22b. The water in the tanks is maintained at an appropriate level by means of operation of the inlet valves 26, which automatically top-up the tanks when the water level drops below a threshold level. The water level in all four tanks remains substantially the same as a result of the right hand tanks 22a, 22b both being in fluid communication, the left hand tanks 20a, 20b both being in fluid communication, and by means of the balance valve assembly 30 providing, during normal use, fluid communication between the inner tanks 20b, 22b.

The humidifier unit 10 of the first embodiment provides resiliency in the unit in a compact foot-print, which allows for routine maintenance of certain consumable / replaceable components and also allows for failure of a single critical component, without needing to affect the humidification capability of the unit. During normal operation, when maximum humidity is demanded of the unit, the pumps 24 operate at full capacity with each pump fully wetting each side of the unit. In this state, full humidification is provided by the unit 10. The use of the matrix sections of the set on one side only is however sufficient when the sections are fully wetted to provide the maximum level of humidity that may be demanded of the unit 10. If the matrix sections of one side only (i.e. set 12 or set 14) are used to provide the maximum level of humidification, operation of only one pump 24 (the pump associated with the relevant side) is required. It will be appreciated that there is a limit to the amount of moisture that air can take on when passing via a set of wetted matrix sections, and that in the present embodiment the extra moisture than is in practice added by the second set of removable sections is very low, if not negligible, so that either of the first set and the second set could, without the help of the other, provide the same level of humidification. When both sides are fully wetted, most of the water held in the second set of sections of wetted matrix trickles down into the tanks below for recirculation, because the air is unable to take on much more moisture.

The humidifier unit 10 offers significant resiliency to failure and may be operated for very long periods of time, possibly substantially indefinitely, without any down-time. It may be considered as an "always-on" humidifier unit. Such resiliency may be required in certain critical applications, such as in a data centre where there is no redundancy provided in the humidification unit(s) installed. The duplication of critical components offers redundancy in the event of a single-point failure. It also allows for replacement and/or maintenance of such components during continued operation. In such circumstances (the removal or failure of a component) requires the humidification unit 10 to be operated differently from the normal mode of operation. Examples of special modes of operation will now be described.

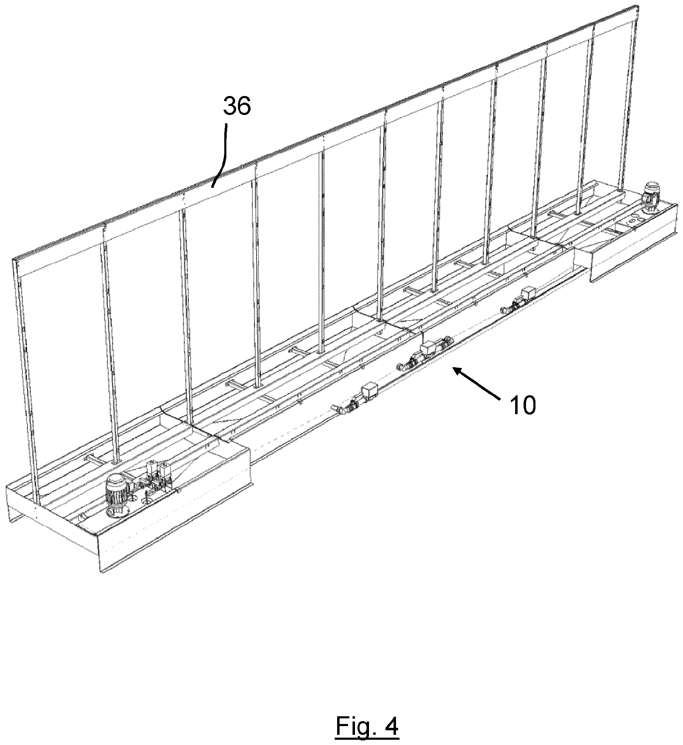

One of the first and second sets 12, 14 of removable sections may be removed for maintenance and/or replacement, whilst leaving the other of the first and second sets of removable sections in operation. (For example, all sections of the first set 12 of removable sections may be removed, whilst leaving the sections of the second set of removable sections in operation.) Each column of removable wetted matrix panels is hung from a hanging rail 36 on the unit 10 (see Figure 4 which shows the unit 10 with all removable sections removed). During the removal of a set of sections, the balancing valve 30 is left open, and the pump 24 associated with the set of sections being removed is disabled, leaving the other pump to operate as normal. (The inlets 26 - typically closed - and drains 28 - also typically closed - are also allowed to operate as normal.) Thus, either set 12, 14 of wetted matrix sections may be completely removed, whilst still operating the humidifier unit 10 at its maximum required rate of humidification. The operation of the humidifier unit in the case where the sections of wetted matrix in one set are not used and the sections of wetted matrix in the other set are operated at full operating capacity, will be referred to below as operation in a half-wetted mode. In this mode, the disabled pump does not recirculate water, but the water levels between the tanks are maintained at appropriate levels by means of the balancing valve 30 being left open.

Modes of failure may be detected by use of the control units 40, one of which (the left hand control unit which controls the second set 14 of wetted matrix sections) is shown schematically in Figure 5. An equivalent control unit (not shown) is provided on the right hand side for controlling the first set 12 of wetted matrix sections. The control unit 40 is arranged to operate (turn on or off - open or close) the left hand water inlet valve 26, the left hand pump 24, the left hand water drain valve 28, and the centre balance valve 30 (the other control unit is also independently able to control the centre balance valve). The control unit 40 receives a first input 42 from the water drain valve to indicate whether water is draining as expected. The control unit 40 receives a second input 44 from the pump outlet to indicate whether water is pumping out expected. The control unit 40 receives a third input 46 from the water inlet to indicate whether water is flowing into the tank 20a as expected. The control unit 40 receives a fourth input 48 from the tank balance valve to indicate whether the valve is operating correctly. The control unit 40 further receives a fifth input 50 to indicate whether water is overflowing from the overflow valve. Lastly, the control unit receives a sixth input 52 from the other control unit which indicates the status of the other control unit (e.g. operating correctly, or not operating correctly - i.e. if faulty/disabled). It will be seen that from a set of known outputs from the control unit (e.g. "operate pump", "close inlet valve", "close drain valve", "open balance valve") it will be possible for the control unit 40 to determine whether there has been a failure, either in the operation of the components controlled by the control unit or in the other control unit, by means of analysis of the six inputs 42, 44, 46, 48, 50, 52. The control unit 40 can also identify the likely cause from such analysis of the six inputs. It will be appreciated that other inputs may additionally or alternatively be measured and monitored, including for example an input - similar to the second input described above - that comes from a flow sensor which measures the flow of water within or to the wetted matrix sections.

By way of example, special modes of operation resulting from failure in given parts of the humidifier unit 10 will now be described.

In the event of a failure in one of the two inlet valves 26 to open when close (a "fail-to-open" case), water may be provided to all tanks by means of maintaining the tank balance valve 30 open and supplying water with the other inlet valve. In the event of a failure in one of the two inlet valves 26 in the fail-to-close, when already open, case, water may be drained by use of a combination of both drain valves 28 and the over flow outlets 32, until the water supply upstream of the inlet valve 26 can be closed-off manually. Repair or replacement may subsequently require the tank in which the faulty inlet valve 26 is located to be emptied/isolated, requiring the use of the half-wetted mode of operation.

In the event of a failure in one of the two outlet drain valves 28 causing the valve to fail to close when opened (the "fail-to-close" case), the tanks associated with the failed outlet drain valve 28 may be isolated from the other tanks by closing the water balance valve 30, and the humidifier unit 10 may then be operated in the half-wetted mode of operation, until the failed drain valve 28 is replaced/repaired. Water draining from the wetted matrix that is caught in the tank associated with the failed valve 28 will be drained to waste requiring more water to be supplied by the inlet 26 associated with the other tank, but operation may still be continued (because water can be supplied at a rate faster than it drains and is used/evaporates).

The failure in one of the two outlet drain valves 28 causing the valve to fail to open when closed (a "fail-to-open" case), which will typically occur during the performance of a water refresh in a given tank, is deemed not to be a critical failure. An alert may be set, and repair replacement of the valve 28 may be effected later, by isolating the tank (by closing the tank balance valve 30), disabling the pump 24 in the affected tank (and then operating in the half-wetted mode of operation), and then employing other means to drain the tank.

In the event of a failure in one of the two pumps 24, or its power supply 34, the pump 24 may be electrically isolated by the control unit 40, and the humidifier unit 10 operated in the half-wetted mode of operation, until the suitable repair or replacement is completed. Such a failure may be detected by means of knowing that a pump is called for operation but no flow of water is detected from the pump and/or to or within the associated wetted matrix sections.

It will be seen that failure / replacement of a component in any one of the following types of failure can be accommodated by the humidifier unit 10: (i) replacement of any or all panels 18 of one or other of the two sets 12, 14 of removable sections of wetted matrix, (ii) failure or removal of one of the two pumps 24, (iii) failure or removal of one of the two water inlets 26, (iv) failure or removal of one of the two water drain outlets 28, (v) failure or removal of one or other of the two control units 40, (vi) failure or removal any other components that are otherwise needed to cause operation of one only of the two sets of wetted matrix sections. For example, the half-wetted mode of operation enables the humidifier unit 10 to operate at normal operating capacity (e.g. providing the same levels of maximum humidification as provided when operating in the normal mode) in the event of all of the sections of wetted matrix belonging to a single set 12, 14 are removed (or otherwise rendered non-operational), provided that the components (including pumps etc.) needed to operate the other set 12, 14 are otherwise unaffected. The same humidifier unit 10 can also operate at normal operating capacity (by means of operating in the half-wetted over-driven mode of operation) in the event that one of the two pumps 24 is removed or otherwise rendered non-operational, provided that the components (including the pump) associated with the tank(s) belonging to the other pump 24 are otherwise unaffected (and therefore still operational).

The control unit 40 also controls other modes of operation of the humidifier including for example, the emptying and refilling of the water tanks 20a, 20b, 22a, 22b which ensure that the water in a tank remains fresh. During such a cycle of emptying and refilling a tank, the water balance valve 30 is closed so as to isolate the left hand tanks 20a, 20b from the right hand tanks 22a, 22b, and the humidifier unit 10 operates using the water in the other tanks not being emptied and refilled. The water in the tank to be refreshed is then drained via the drain valve 28 (opened) at a rate that exceeds the rate of water being introduced in the tank by means of water draining from the matrix that is being fed water from the other tank. (The inlet valve 26 may need to be operated in the other tank if the water level falls too much during this time.) Once all water has drained out, the emptied tank may then be refilled by closing the drain valve 28 and opening the inlet valve 26. Normal operation may then be resumed, or another tank emptied and refilled. This refreshing of water in the tanks may be conducted once every 24 hours, particularly if the system has not been utilised in this time which might otherwise run the risk of the water in the tanks from stagnating.

The humidifier unit of the first embodiment is of particular use within a data centre which requires a resilient humidifier unit. For example the humidifier unit may be provided as part of the equipment used in an indirect air cooling assembly for providing cooling to a data centre, there being no spare humidifier unit for use in the event of a failure of the humidifier unit to operate (i.e. a failure that cannot be overcome by means of operating in a special mode of operation). Resiliency is provided within the humidifier unit so that a redundant humidifier unit is not additionally required.

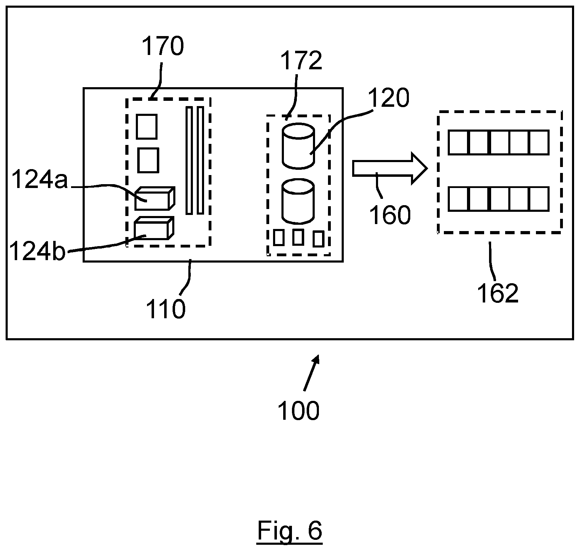

One aspect of the present invention may be viewed as providing a data centre cooling system using a humidifier unit having inherent resiliency. Thus, a second embodiment of the invention, schematically illustrated by Figure 6 of the attached drawings, provides a data centre 100 incorporating a humidifier unit 110 for providing cooled air 160 for cooling IT equipment 162 in the data centre, wherein the humidifier unit 110 comprises critical components 170 and shared non-critical components 172, wherein each critical component has a corresponding redundant critical component, the critical component and its corresponding redundant critical component both utilising the same one or more shared non-critical components when operating. It may be that the critical component and its corresponding redundant critical component are arranged to operate in parallel during normal operation. It may be one water pump 124a is one of the critical components, whereas another water pump 124b is its corresponding redundant critical component. It may be that a water tank 120 is deemed non-critical, and may therefore be shared. One water tank 120 may for example be arranged to receive water from a section of wetted matrix associated with one critical component, whilst also being be arranged to receive water from a different section of wetted matrix associated with the corresponding redundant critical component. It may be that the frame on which removable wetted matrix panels are mounted is deemed non-critical, and may therefore be shared. As a result of the present invention it has been appreciated that there would be advantage in providing a humidifier unit having inherent resiliency to a single-point failure, particularly within the context of providing cooling air for use in a data centre, or other mission-critical facility. It is believed that the potential advantage of providing a resilient humidifier unit has not previously been appreciated by those skilled in the art.

Whilst the present invention has been described and illustrated with reference to particular embodiments, it will be appreciated by those of ordinary skill in the art that the invention lends itself to many different variations not specifically illustrated herein. By way of example only, certain possible variations will now be described.

The arrangement may be such that during normal operation, when maximum humidity is demanded of the unit, the pumps operate at significantly below full capacity so that each side of the unit is less than fully wetted but such that together they enable the humidifier unit to provide full humidification. It may then be the case that the same level of humidification can be provided by the use of fully wetted matrix sections on one side only. Thus, if the matrix sections of one side only are used to provide the maximum level of humidification, operation of only one pump is required, but the pump is required to operate at full capacity (i.e. providing a significantly higher rate of pumping than required of the pump during normal operation when all sets are wetted, albeit not fully wetted).

It will be appreciated that instead of providing four tanks, a different number may be provided. Two tanks may be sufficient, one on the left associated with one pump that supplies water to the wetted matrix panels on the air-off side of the humidifier, the other tanks being on the right and being associated with the single pump that supplies water to the wetted matrix panels on the air-on side of the humidifier.

It may in certain embodiments be deemed unnecessary to provide multiple water inlets or multiple water drains. Such parts may be deemed as sufficiently reliable or non-critical that redundancy is not necessary for such parts.

There may be additional modes of operation in which only some of the sets of removable sections are wetted by water, yet without failure or removal of any critical parts of the humidifier unit.

Instead of each control unit being associated with one pump only, it may be the case that each pump receives two control signals, one from each control unit, when operating normally (with a slave-master type control being employed), so that in the event of failure of a control unit, both pumps may still be controlled by the surviving control unit.

Instead of providing two control units, a single central control unit with sufficient resiliency may be provided. In such a case, each pump may be connected to a respective locally positioned junction box, from which control signals are wired back to the central control unit.

## Claims

1. A data centre including a humidifier unit (10) arranged to provide cooling air for use in cooling IT equipment in the data centre, **characterised in that** the humidifier unit (10) comprises in a single unit
two or more sets of removable sections (12, 14) that in use form a wetted matrix system for humidifying air flowing along a flow path from one side of the wetted matrix system to the other (16a, 16b), the two or more sets of removable sections (12, 14) including a first set (12) of one or more removable sections and a second set (14) of one or more removable sections,
one or more water tanks (20, 22) for holding water, and
two or more pumps (24), each pump being configured to pump water held in at least one such water tank (20, 22) to at least one of the two or more sets of removable sections (12, 14),
and **in that**
the humidifier unit (10) is configured to operate in a first mode of operation in which all of the sets of removable sections (12, 14) are wetted by water from the one or more water tanks (20, 22) by means of operation of at least one of the two or more pumps (24), the first mode of operation corresponding to a maximum level of humidification required of the humidifier unit (10) during normal operation,
and
the humidifier unit (10) is configured to operate in a second mode of operation both in the event of:
(a) one or more, but not all, sets of removable sections (12, 14) being removed or otherwise rendered non-operational, the pumps (24) otherwise being unaffected, and
(b) one or more, but not all, pumps (24) being removed or otherwise rendered non-operational, the removable sections (12, 14) otherwise being unaffected,
such that in the second mode of operation the humidification unit (10) is still able to deliver said maximum level of humidification.

2. A data centre according to claim 1, wherein there are two or more sets of water tanks (20, 22) for holding water, the two or more sets comprising a first set of one or more water tanks (20a, 20b) and a second set of one or more water tanks (22a, 22b), wherein all of the two or more sets of water tanks are arranged to receive drain water from both the first and the second sets of removable sections (12, 14).

3. A data centre according to claim 2, wherein the first set of water tanks (20) is arranged to feed water to at least the first set of removable sections (12), and the second set of water tanks (22) is arranged to feed water to at least the second set of removable sections (14).

4. A data centre according to claim 2 or claim 3, further comprising an isolation valve (30) which is operable to bring one set of water tanks (20) into fluid communication with another set of water tanks (22) and is operable to isolate said one set of water tanks (20) from said another set of water tanks (22).

5. A data centre according to any preceding claim, wherein the second set of removable sections (14) is positioned in series with the first set of removable sections (12) such that when both the first set (12) and the second set (14) are in use, air flows via both the first (12) and second (14) sets.

6. A data centre according to any preceding claim, further comprising two or more water inlets (26) for supplying fresh water to the one or more water tanks (20, 22), and wherein the humidifier unit (10) is arranged to continue humidifying air flowing along the flow path (16) in the event of failure of any one of the two or more water inlets (26).

7. A data centre according to any preceding claim, further comprising two or more water outlets (28) from the one or more water tanks for draining water from the water tanks (20, 22), and wherein the humidifier unit (10) is arranged to continue humidifying air flowing along the flow path (16) in the event of failure of any one of the two or more water outlets (28).

8. A data centre according to the combination of claims 6 and 7, wherein the humidifier unit (10) is arranged to continue humidifying air flowing along the flow path (16) in the event of failure of any one component of the group of components consisting of the two or more pumps (24), the two or more water outlets (28), and the two or more water inlets (26).

9. A data centre according to any preceding claim, further comprising a control unit which is arranged to receive an input concerning whether one or more sets of removable sections (12, 14) are operational or not and an input concerning whether one or more pumps (24) are operational or not, and is arranged in dependence on the inputs so received to cause the humidifier unit (10) to operate in the first mode of operation if the inputs indicate that all sets of removable sections (12, 14) are operational and all pumps (24) are operational, and to cause the humidifier unit (10) to operate in the second mode of operation if the inputs indicate one of the sets of removable sections (12, 14) and the pumps (24) is non-operational.

10. A data centre according to claim 9, wherein the humidifier unit (10) comprises at least one such control unit for each of the two or more pumps (24), and wherein the humidifier unit (10) is arranged to continue humidifying air flowing along the flow path (16) in the event of failure of any one of the control units.

11. A data centre according to any preceding claim, wherein
the humidifier unit (10) comprises critical components and shared non-critical components,
each critical component has a corresponding redundant critical component, the critical component and its corresponding redundant critical component both utilising the same one or more shared non-critical components when operating,
the first set of removable wetted matrix sections (12) being a critical component,
the second set of removable wetted matrix sections (14) being a corresponding redundant critical component,
a first pump of the two or more pumps (24) being a critical component,
a second pump of the two or more pumps (24) being a corresponding redundant critical component.

12. A data centre according to claim 11, wherein each of the first and second sets of removable wetted matrix sections (12, 14) are held in at least one or more frames, the one or more frames being in the form of one or more shared non-critical components.

13. A data centre according to claim 11 or claim 12, wherein the one or more water tanks (20, 22) are in the form of shared non-critical components.

14. A humidifier unit (10) configured for use as the humidifier unit of the data centre according to any preceding claim, the humidifier unit (10) comprising in a single unit
two or more sets of removable sections (12, 14) that in use form a wetted matrix system for humidifying air flowing along a flow path (16) from one side of the wetted matrix system to the other,
one or more water tanks (20, 22) for holding water, and
two or more pumps (24), each pump (24) being configured to pump water held in at least one such water tank (20, 22) to at least one of the two or more sets of removable sections (12, 14).

15. A method of cooling IT equipment in a data centre with the use of a resilient wetted matrix humidifier unit (10) according to any one of claims 1-14, wherein the method comprises operating the humidifier unit in the first mode of operation, and subsequently operating the humidifier unit in the second mode of operation.

## Patentansprüche

1. Rechenzentrum mit einer Befeuchtungseinheit (10), die zur Bereitstellung von Kühlluft zur Kühlung von IT-Geräten im Rechenzentrum eingerichtet ist, **dadurch gekennzeichnet, dass** die Befeuchtungseinheit (10) in einer einzigen Einheit umfasst:
zwei oder mehr Sätze entfernbarer Abschnitte (12, 14), die im Gebrauch ein benetztes Matrixsystem zum Befeuchten von Luft bilden, die entlang eines Strömungswegs von einer Seite des benetzten Matrixsystems zur anderen (16a, 16b) strömt, wobei die zwei oder mehr Sätze von entfernbaren Abschnitten (12, 14) einen ersten Satz (12) von einem oder mehreren entfernbaren Abschnitten und einem zweiten Satz (14) von einem oder mehreren entfernbaren Abschnitten umfassen,
einen oder mehrere Wassertanks (20, 22) zum Halten von Wasser und
zwei oder mehr Pumpen (24), wobei jede Pumpe konfiguriert ist, um Wasser, das in mindestens einem solchen Wassertank (20, 22) gehalten wird, zu mindestens einem der beiden oder mehreren Sätze abnehmbarer Abschnitte (12, 14) zu pumpen,
und dass die Befeuchtungseinheit (10) so konfiguriert ist, dass sie in einem ersten Betriebsmodus arbeitet, in dem alle Sätze von entfernbaren Abschnitten (12, 14) mit Wasser aus dem einen oder den mehreren Wassertanks (20, 22) durch den Betrieb von mindestens einer der zwei oder mehr Pumpen (24) benetzt werden, wobei die erste Betriebsart dem Maximalniveau der Befeuchtung der Befeuchtungseinheit (10), die im Normalbetrieb erforderlich ist, entspricht
und
die Befeuchtungseinheit (10) so konfiguriert ist, dass sie im zweiten Betriebsmodus in den beiden folgenden Fällen arbeitet:
(a) ein oder mehrere, aber nicht alle Sätze entfernbarer Abschnitte (12, 14) sind ausgebaut oder auf andere Weise außer Betrieb gesetzt, wobei die Pumpen (24) ansonsten nicht betroffen sind, und
(b) eine oder mehrere, aber nicht alle Pumpen (24) sind entfernt oder auf andere Weise außer Betrieb gesetzt, wobei die entfernbaren Abschnitte (12, 14) ansonsten nicht betroffen sind, so dass in der zweiten Betriebsart die Befeuchtungseinheit (10) immer noch in der Lage ist, den maximalen Befeuchtungsgrad zu liefern.

2. Rechenzentrum nach Anspruch 1, wobei zwei oder mehr Sätze von Wassertanks (20, 22) zum Halten von Wasser vorhanden sind, wobei die zwei oder mehr Sätze einen ersten Satz von einem oder mehreren Wassertanks (20a, 20b) und einen zweiten Satz von einem oder mehreren Wassertanks (22a, 22b) umfassen, wobei alle dieser zwei oder mehreren Sätze von Wassertanks angeordnet sind, um Abwasser sowohl vom ersten als auch vom zweiten Satz von entfernbaren Abschnitten (12, 14) aufzunehmen.

3. Rechenzentrum nach Anspruch 2, wobei der erste Satz von Wassertanks (20) so angeordnet ist, dass Wasser mindestens dem ersten Satz entfernbarer Abschnitte (12) zugeführt wird, und der zweite Satz von Wassertanks (22) so angeordnet ist, dass zumindest dem zweiten Satz von entfernbaren Abschnitten (14) Wasser zugeführt wird.

4. Rechenzentrum nach Anspruch 2 oder Anspruch 3, das ferner ein Isolierungsventil (30) umfasst,
das so betrieben werden kann, dass ein Satz von Wassertanks (20) in Fluidverbindung mit einem anderen Satz von Wassertanks (22) gebracht und so betrieben werden kann, dass der eine Satz von Wassertanks (20) von dem anderen Satz von Wassertanks (22) isoliert werden kann.

5. Rechenzentrum nach einem der vorhergehenden Ansprüche, wobei der zweite Satz aus entfernbaren Abschnitten (14) in Reihe mit dem ersten Satz entfernbarer Abschnitte (12) derart positioniert ist, dass, wenn sowohl der erste Satz (12) als auch der zweite Satz (14) in Gebrauch sind, Luft sowohl über den ersten (12) als auch den zweiten (14) Satz strömt.

6. Rechenzentrum nach einem der vorhergehenden Ansprüche, ferner mit zwei oder mehreren Wassereinlässen (26) zur Frischwasserversorgung des einen oder der mehreren Wassertanks (20, 22), und wobei die Befeuchtungseinheit (10) angeordnet ist, um die Befeuchtung der Luft, die entlang des Strömungswegs (16) strömt, im Falle eines Ausfalls eines der zwei oder mehr Wassereinlässe (26) fortzusetzen.

7. Rechenzentrum nach einem der vorhergehenden Ansprüche, ferner umfassend zwei oder mehr mehrere Wasserauslässe (28) aus dem einen oder den mehreren Wassertanks zum Ablassen von Wasser aus den Wassertanks (20, 22), und wobei die Befeuchtungseinheit (10) so angeordnet ist, dass sie die entlang des Strömungsweges (16) strömende Befeuchtungsluft im Falle eines Ausfalls von einem der zwei oder mehr Wasserauslässe (28) befeuchtet.

8. Rechenzentrum nach einer Kombination der Ansprüche 6 und 7, wobei die Befeuchtungseinheit (10) so angeordnet ist, dass sie die entlang des Strömungswegs (16) strömende Luft im Falle eines Ausfalls einer Komponente der Gruppe von Komponenten weiterbefeuchtet, bestehend aus den zwei oder mehr Pumpen (24), den zwei oder mehr Wasserauslässen (28) und den zwei oder mehr Wassereinlässen (26).

9. Rechenzentrum nach einem der vorhergehenden Ansprüche, das ferner eine Steuerungseinheit umfasst, die angeordnet ist, um eine Eingabe zu empfangen, ob einer oder mehrere Sätze von entfernbaren Abschnitten (12, 14) betriebsbereit sind oder nicht, und eine Eingabe, die angibt, ob eine oder mehrere Pumpen (24) betriebsbereit sind oder nicht, und die in Abhängigkeit von den so empfangenen Eingaben angeordnet ist, um zu bewirken, dass die Befeuchtungseinheit (10) in der ersten Betriebsart arbeitet, wenn die Eingaben anzeigen, dass alle Sätze entfernbarer Abschnitte (12, 14) betriebsbereit sind und alle Pumpen (24) betriebsbereit sind und um zu bewirken, dass die Befeuchtungseinheit (10) in der zweiten Betriebsart arbeitet, wenn die Eingaben anzeigen, dass einer der Sätze der entfernbaren Abschnitte (12, 14) und der Pumpen (24) nicht betriebsbereit ist.

10. Rechenzentrum nach Anspruch 9, wobei die Befeuchtungseinheit (10) mindestens eine solche Steuereinheit für jede der zwei oder mehr Pumpen (24) umfasst, und wobei die Befeuchtungseinheit (10) so angeordnet ist, dass sie die entlang des Strömungswegs (16) strömende Luft im Falle eines Ausfalls einer der Steuereinheiten weiter befeuchtet.

11. Rechenzentrum nach einem der vorhergehenden Ansprüche, wobei die Befeuchtungseinheit (10) kritische Komponenten und gemeinsame nicht kritische Komponenten aufweist,
jede kritische Komponente eine entsprechende redundante kritische Komponente aufweist, wobei die kritische Komponente und ihre entsprechende redundante kritische Komponente im Betrieb beide dieselbe oder mehrere gemeinsame nicht kritische Komponenten verwenden,
der erste Satz entfernbarer benetzter Matrixabschnitte (12) eine kritische Komponente ist,
der zweite Satz entfernbarer benetzter Matrixabschnitte (14) eine entsprechende redundante kritische Komponente ist,
eine erste Pumpe der zwei oder mehr Pumpen (24) eine kritische Komponente ist,
eine zweite Pumpe der zwei oder mehr Pumpen (24) eine entsprechende redundante kritische Komponente ist.

12. Rechenzentrum nach Anspruch 11, wobei jeder der ersten und zweiten Sätze entfernbarer benetzter Matrixabschnitte (12, 14) in mindestens einem oder mehreren Rahmen gehalten wird, wobei der eine oder die mehreren Rahmen die Form einer oder mehrerer gemeinsamer nicht kritischer Komponenten aufweisen.

13. Rechenzentrum nach Anspruch 11 oder Anspruch 12, wobei das eine oder die mehreren Wassertanks (20, 22) in Form gemeinsamer nicht kritischer Komponenten vorliegen.

14. Befeuchtungseinheit (10), die zur Verwendung als Befeuchtungseinheit des Rechenzentrums nach einem der vorhergehenden Ansprüche konfiguriert ist, wobei die Befeuchtungseinheit (10) in einer einzelnen Einheit zwei oder mehr Sätze entfernbarer Abschnitte (12, 14), die im Gebrauch ein benetztes Matrixsystem zum Befeuchten von Luft bilden, die entlang eines Strömungswegs (16) von einer Seite des benetzten Matrixsystems zur anderen strömt,
einen oder mehrere Wassertanks (20, 22) zum Halten von Wasser und
zwei oder mehr Pumpen (24) umfasst, wobei jede Pumpe (24) konfiguriert ist, um Wasser, das in mindestens einem solchen Wassertank (20, 22) gehalten wird, zu mindestens einem der beiden oder mehreren Sätze von entfernbaren Teilen (12, 14) zu pumpen.

15. Verfahren zum Kühlen von IT-Geräten in einem Rechenzentrum mithilfe einer ausfallsicheren Befeuchtungseinheit (10) mit benetzter Matrix nach einem der Ansprüche 1 bis 14, wobei das Verfahren das Betreiben der Befeuchtungseinheit in der ersten Betriebsart oder das Betreiben der Befeuchtungseinheit in der zweiten Betriebsart umfasst.

## Revendications

1. Centre informatique comprenant une unité d'humidification (10) agencée pour fournir de l'air de refroidissement pour une utilisation dans le refroidissement d'un équipement de technologies de l'information dans le centre informatique, **caractérisé en ce que** l'unité d'humidification (10) comprend dans une unité unique,
deux ensembles ou plus de sections amovibles (12, 14) qui, en utilisation, forment un système matriciel humidifié pour humidifier l'air s'écoulant le long d'un trajet d'écoulement d'un côté du système matriciel humidifié à l'autre (16a, 16b), les deux ensembles ou plus de sections amovibles (12, 14) comprenant un premier ensemble (12) d'une ou de plusieurs sections amovibles et un deuxième ensemble (14) d'une ou de plusieurs sections amovibles,
un ou plusieurs réservoirs d'eau (20, 22) pour contenir de l'eau, et
deux pompes (24) ou plus, chaque pompe étant configurée pour pomper l'eau contenue dans au moins un tel réservoir d'eau (20, 22) vers au moins l'un des deux ensembles ou plus de sections amovibles (12, 14),
et **en ce que**
l'unité d'humidification (10) est configurée pour fonctionner dans un premier mode de fonctionnement dans lequel la totalité des ensembles de sections amovibles (12, 14) sont humidifiés par l'eau provenant desdits un ou plusieurs réservoirs d'eau (20, 22) par le fonctionnement d'au moins l'une des deux pompes (24) ou plus, le premier mode de fonctionnement correspondant à un niveau d'humidification maximum requis de l'unité d'humidification (10) pendant un fonctionnement normal, et
l'unité d'humidification (10) est configurée pour fonctionner dans un deuxième mode de fonctionnement à la fois dans le cas où :
(a) un ou plusieurs, mais pas la totalité, des ensembles de sections amovibles (12, 14) sont retirés ou autrement rendus non opérationnels, les pompes (24) n'étant pas autrement affectées, et
(b) une ou plusieurs, mais pas la totalité, des pompes (24) sont retirées ou autrement rendues non opérationnelles, les sections amovibles (12, 14) n'étant pas autrement affectées,
de sorte que, dans le deuxième mode de fonctionnement, l'unité d'humidification (10) est encore capable de délivrer ledit niveau d'humidification maximum.

2. Centre informatique selon la revendication 1, dans lequel il y a deux ensembles ou plus de réservoirs d'eau (20, 22) pour contenir de l'eau, les deux ensembles ou plus comprenant un premier ensemble d'un ou de plusieurs réservoirs d'eau (20a, 20b) et un deuxième ensemble d'un ou de plusieurs réservoirs d'eau (22a, 22b), dans lequel les deux ensembles ou plus de réservoirs d'eau sont tous agencés pour recevoir l'eau d'évacuation à la fois des premier et deuxième ensembles de sections amovibles (12, 14).

3. Centre informatique selon la revendication 2, dans lequel le premier ensemble de réservoirs d'eau (20) est agencé pour fournir de l'eau au moins au premier ensemble de sections amovibles (12), et le deuxième ensemble de réservoirs d'eau (22) est agencé pour fournir de l'eau au moins au deuxième ensemble de sections amovibles (14).

4. Centre informatique selon la revendication 2 ou la revendication 3, comprenant en outre une vanne d'isolement (30) qui peut être utilisée pour amener un ensemble de réservoirs d'eau (20) en communication fluidique avec un autre ensemble de réservoirs d'eau (22) et qui peut être utilisée pour isoler ledit un ensemble de réservoirs d'eau (20) dudit un autre ensemble de réservoirs d'eau (22).

5. Centre informatique selon l'une quelconque des revendications précédentes, dans lequel le deuxième ensemble de sections amovibles (14) est positionné en série avec le premier ensemble de sections amovibles (12) de sorte que, lorsque le premier ensemble (12) et le deuxième ensemble (14) sont tous deux en utilisation, l'air s'écoule à la fois à travers les premier (12) et deuxième (14) ensembles.

6. Centre informatique selon l'une quelconque des revendications précédentes, comprenant en outre deux entrées d'eau (26) ou plus pour fournir de l'eau fraîche auxdits un ou plusieurs réservoirs d'eau (20, 22), et dans lequel l'unité d'humidification (10) est agencée pour continuer d'humidifier l'air s'écoulant le long du trajet d'écoulement (16) dans le cas d'une défaillance de l'une quelconque des deux entrées d'eau (26) ou plus.

7. Centre informatique selon l'une quelconque des revendications précédentes, comprenant en outre deux sorties d'eau (28) ou plus provenant desdits un ou plusieurs réservoirs d'eau pour évacuer l'eau des réservoirs d'eau (20, 22), et dans lequel l'unité d'humidification (10) est agencée pour continuer d'humidifier l'air s'écoulant le long du trajet d'écoulement (16) dans le cas d'une défaillance de l'une quelconque des deux sorties d'eau (28) ou plus.

8. Centre informatique selon la combinaison des revendications 6 et 7, dans lequel l'unité d'humidification (10) est agencée pour continuer d'humidifier l'air s'écoulant le long du trajet d'écoulement (16) dans le cas d'une défaillance de n'importe quel composant du groupe de composants consistant en les deux pompes (24) ou plus, les deux sorties d'eau (28) ou plus, et les deux entrées d'eau (26) ou plus.

9. Centre informatique selon l'une quelconque des revendications précédentes, comprenant en outre une unité de commande qui est agencée pour recevoir une entrée indiquant si un ou plusieurs ensembles de sections amovibles (12, 14) sont opérationnels ou non et une entrée indiquant si une ou plusieurs pompes (24) sont opérationnelles ou non, et est agencée en fonction des entrées ainsi reçues pour amener l'unité d'humidification (10) à fonctionner dans le premier mode de fonctionnement si les entrées indiquent que tous les ensembles de sections amovibles (12, 14) sont opérationnels et toutes les pompes (24) sont opérationnelles, et pour amener l'unité d'humidification (10) à fonctionner dans le deuxième mode de fonctionnement si les entrées indiquent que l'un des ensembles de sections amovibles (12, 14) et des pompes (24) n'est pas opérationnel.

10. Centre informatique selon la revendication 9, dans lequel l'unité d'humidification (10) comprend au moins une telle unité de commande pour chacune des deux pompes (24) ou plus, et dans lequel l'unité d'humidification (10) est agencée pour continuer d'humidifier l'air s'écoulant le long du trajet d'écoulement (16) dans le cas d'une défaillance de l'une quelconque des unités de commande.

11. Centre informatique selon l'une quelconque des revendications précédentes, dans lequel
l'unité d'humidification (10) comprend des composants critiques et des composants non critiques partagés,
chaque composant critique a un composant critique redondant correspondant, le composant critique et son composant critique redondant correspondant utilisant tous deux les mêmes un ou plusieurs composants non critiques partagés en fonctionnement,
le premier ensemble de sections de matrice humidifiées amovibles (12) étant un composant critique,
le deuxième ensemble de sections de matrice humidifiées amovibles (14) étant un composant critique redondant correspondant,
une première pompe des deux pompes (24) ou plus étant un composant critique,
une deuxième pompe des deux pompes (24) ou plus étant un composant critique redondant correspondant.

12. Centre informatique selon la revendication 11, dans lequel chacun des premier et deuxième ensembles de sections de matrice humidifiées amovibles (12,14) est maintenu dans au moins un cadre ou plus, ledit un cadre ou plus étant sous la forme d'un ou de plusieurs composants non critiques partagés.

13. Centre informatique selon la revendication 11 ou la revendication 12, dans lequel lesdits un ou plusieurs réservoirs d'eau (20, 22) sont sous la forme de composants non critiques partagés.

14. Unité d'humidification (10) configurée pour une utilisation en tant qu'unité d'humidification du centre informatique selon l'une quelconque des revendications précédentes, l'unité d'humidification (10) comprenant dans une unité unique
deux ensembles ou plus de sections amovibles (12, 14) qui, en utilisation, forment un système matriciel humidifié pour humidifier l'air s'écoulant le long d'un trajet d'écoulement (16) d'un côté du système matriciel humidifié à l'autre,
un ou plusieurs réservoirs d'eau (20, 22) pour contenir de l'eau, et
deux pompes (24) ou plus, chaque pompe (24) étant configurée pour pomper l'eau contenue dans au moins un tel réservoir d'eau (20, 22) vers au moins l'un des deux ensembles ou plus de sections amovibles (12, 14).

15. Procédé de refroidissement d'un équipement de technologies de l'information dans un centre informatique en utilisant une unité d'humidification matricielle humidifiée (10) résiliente selon l'une quelconque des revendications 1 à 14, dans lequel le procédé comprend la mise en oeuvre de l'unité d'humidification dans le premier mode de fonctionnement, et ensuite la mise en oeuvre de l'unité d'humidification dans le deuxième mode de fonctionnement.
